(19) Europäisches Patentamt
European Patent Office
Office européen des brevets

(11) **EP 2 100 158 B1**

(12) **EUROPÄISCHE PATENTSCHRIFT**

(45) Veröffentlichungstag und Bekanntmachung des Hinweises auf die Patenterteilung:
**04.09.2013 Patentblatt 2013/36**

(21) Anmeldenummer: **07846386.6**

(22) Anmeldetag: **05.12.2007**

(51) Int Cl.:
*G01R 33/483* (2006.01)      *G01R 33/561* (2006.01)
*G01R 33/58* (2006.01)

(86) Internationale Anmeldenummer:
**PCT/DE2007/002183**

(87) Internationale Veröffentlichungsnummer:
**WO 2008/071155 (19.06.2008 Gazette 2008/25)**

(54) **VERFAHREN ZUR GEWINNUNG VON AMPLITUDEN- UND PHASENVERLÄUFEN VON HF-PULSEN FÜR DIE RÄUMLICH-SELEKTIVE ANREGUNG**

METHOD FOR OBTAINING AMPLITUDE AND PHASE PROFILES OF RF PULSES FOR SPATIALLY SELECTIVE EXCITATION

PROCÉDÉ D'OBTENTION DES COURBES D'AMPLITUDE ET DE PHASE D'IMPULSIONS HF EN VUE D'UNE EXCITATION SPATIALE SÉLECTIVE

(84) Benannte Vertragsstaaten:
**AT BE BG CH CY CZ DE DK EE ES FI FR GB GR HU IE IS IT LI LT LU LV MC MT NL PL PT RO SE SI SK TR**

(30) Priorität: **09.12.2006 DE 102006058162**

(43) Veröffentlichungstag der Anmeldung:
**16.09.2009 Patentblatt 2009/38**

(73) Patentinhaber:
• **Bruker BioSpin MRI GmbH**
**76275 Ettlingen (DE)**
• **Universitätsklinikum Freiburg**
**79106 Freiburg (DE)**

(72) Erfinder: **ULLMANN, Peter**
**76137 Karlsruhe (DE)**

(74) Vertreter: **Kohler Schmid Möbus Patentanwälte Ruppmannstraße 27 70565 Stuttgart (DE)**

(56) Entgegenhaltungen:
**US-A1- 2005 110 488**

• **GRISSOM W ET AL: "Spatial domain method for the design of RF pulses in multicoil parallel excitation" MAGNETIC RESONANCE IN MEDICINE WILEY USA, Bd. 56, Nr. 3, September 2006 (2006-09), Seiten 620-629, XP002475615 ISSN: 0740-3194 in der Anmeldung erwähnt**
• **SAEKHO S ET AL: "Fast-kz three-dimensional tailored radiofrequency pulse for reduced B1 inhomogeneity" MAGNETIC RESONANCE IN MEDICINE WILEY USA, Bd. 55, Nr. 4, April 2006 (2006-04), Seiten 719-724, XP002475616 ISSN: 0740-3194 in der Anmeldung erwähnt**

EP 2 100 158 B1

**Beschreibung**

Die Erfindung betrifft ein Verfahren zur Gewinnung der Amplituden- und Phasenverläufe von HF-Pulsen, welche während des Durchlaufens einer vorgegebenen k-Raum-Trajektorie zur Erzeugung eines n-dimensionalen räumlichen Musters (n>=1) der transversalen Magnetisierung in einem Objekt im Rahmen eines Experiments der ortsaufgelösten magnetischen Resonanz mittels mindestens einer HF-Sendeantenne eines Magnetresonanzmesssystems (MR-Messsystems) eingestrahlt werden.

Ein derartiges Verfahren ist beispielsweise bekannt aus [6].

Die Magnetresonanzbildgebung (MRI: Magnetic Resonance Imaging), auch als Magnetresonanztomographie (MRT) bezeichnet, ist eine weitverbreitete Technik zur nicht-destruktiven Gewinnung von Bildern des Innern eines Untersuchungsobjektes und beruht auf der ortsaufgelösten Messung von Magnetresonanzsignalen aus dem Untersuchungsobjekt. Indem das Untersuchungsobjekt innerhalb eines Grundfeldmagneten einem im Wesentlichen statischen und homogenen magnetischen Grundfeld ausgesetzt wird, werden in ihm enthaltene Kernspins bzgl. der Richtung des Grundfeldes, in der Regel als z-Richtung eines magnetgebundenen Koordinatensystems gewählt, orientiert. Bei der MR-Untersuchung werden durch Einstrahlung von elektromagnetischen HF-Pulsen mittels einer oder mehrerer HF-Sendeantennen die so orientierten Kernspins des Untersuchungsobjekts zu Präzessionsbewegungen angeregt, deren Frequenzen proportional zu den lokalen magnetischen Feldstärken sind. Bei den heute allgemein verwendeten MRI-Verfahren wird den Präzessionsbewegungen der Kernspins durch zeitlich variierte Überlagerungen von Gradientenfeldern $G_x$, $G_y$ und $G_z$, die mit einem Gradientensystem erzeugt werden, für alle drei Raumrichtungen eine räumliche Kodierung, im Allgemeinen als Ortskodierung bezeichnet, aufgeprägt. Diese Ortskodierung wird üblicherweise durch ein Schema in einem dem Ortsraum über eine Fouriertransformation konjugierten Raum, dem sog. k-Raum, beschrieben. Die Transversalkomponente der mit den präzedierenden Kemspins verbundenen Magnetisierung induziert in einer oder mehreren HF-Empfangsantennen, welche das Untersuchungsobjekt umgeben, Spannungssignale. Mittels Pulssequenzen, welche speziell gewählte Abfolgen von HF-Pulsen und Gradientenpulsen enthalten, werden zeitlich veränderliche Magnetresonanzsignale derart erzeugt, dass sie in entsprechende räumliche Abbildungen umgesetzt werden können. Dies erfolgt nach einer von vielen wohlbekannten Rekonstruktionstechniken, nachdem die HF-Signale mittels eines elektronischen Empfangssystems aufgenommen, verstärkt und digitalisiert sowie mittels eines elektronischen Rechnersystems verarbeitet und in zwei-oder dreidimensionalen Datensätzen abgespeichert worden sind. Typischerweise enthält die verwendete Pulssequenz eine Abfolge von Messabläufen, in denen die Gradientenpulse gemäß dem gewählten Lokalisierungsverfahren variiert werden.

Aus US 7,078,899 B2 ist ein Optimierungsverfahren für k-Raum Trajektorien zur Verwendung in der MR-Bildgebung bekannt.

US 5,758,646 A beschreibt ein Verfahren, bei dem MR=Bildgebungssequenzen bestehend aus HF- und Gradientenpulsen bezüglich wichtiger Parameter (z.B. S/N-Verhältnis) optimiert werden, um die Anzahl der zur Auswahl stehenden MR-Bildgebungssequenzen zu reduzieren.

Eine wesentliche Voraussetzung für eine ortsgetreue Abbildung der Kernspins des Untersuchungsobjektes ist, dass die technischen Imperfekfionen des MR-Messsystems vernachlässigbar oder die Abweichungen von dem idealen Verhalten bekannt sind und entsprechend korrigiert werden können.

Die räumlich-selektive Anregung ist eine in der Magnetresonanzbildgebung weit verbreitete Technik, welche dazu genutzt wird, die bei der Anregung erzeugte Transversalmagnetisierung räumlich einzuschränken und/oder deren Amplitude und Phase im Anregungsvolumen räumlich zu variieren. Bei der Schichtselektion, dem häufigsten Fall der selektiven Anregung, wird das Anregungsvolumen auf eine vorgegebene Schicht reduziert. Die mehrdimensionale selektive Anregung, bei welcher das Anregungsvolumen in mehr als einer Richtung eingeschränkt bzw. die Anregung in mehr als einer Richtung moduliert wird, hat ebenfalls zahlreiche Anwendungen hervorgebracht. Zu nennen sind hier die Anregung eines kleinen dreidimensionalen Volumens innerhalb eines wesentlich größeren Untersuchungsobjektes für lokalisierte Spektroskopie, die Abbildung einer selektiv angeregten "Region of Interest" (ROI) mit reduzierten Sichtfeld (FOV: Field of View) zwecks Messzeitverkürzung, die Anregung spezieller, an Strukturen des Untersuchungsobjekts angepasster Volumina oder auch die echo-planare Bildgebung mit reduzierten Echokuglängen. Weiterhin kann die Amplituden- und Phasenmodulation bei der Anregung auch dazu genutzt werden, um nachteilige Effekte eines inhomogenen $B_1$-Feldes der zum Senden verwendeten HF-Antennen zu kompensieren. Dies ist eine Anwendung, welche heutzutage aufgrund der starken Zunahmen von Hochfeld-MRI-Systemen immens an Bedeutung gewonnen hat.

Im Regelfall wurde die räumlich selektive Anregung in der Vergangenheit mittels einer einzelnen HF-Sendeantenne mit einem im Wesentlichen homogenen Sendefeld ($B_1$-Feld) in Kombination mit dem Gradientensystem durchgeführt. Inspiriert durch den Erfolg der Parallelen Bildgebung, bei welcher die Signalaufnahme mit einer Anordnung von mehreren HF-Empfangsantennen, in der Fachliteratur auch als Antennenarray bezeichnet, durchgeführt wird, ist man inzwischen dazu übergegangen auch bei der selektiven Anregung solche Arrays zum Senden einzusetzen. Damit ist man in der Lage, die Ortskodierung, welche bei der selektiven Anregung in Analogie zur Akquisition durch Variation von Gradientenfeldern realisiert wird, partiell durch sog. Sensitivitätskodierung zu ersetzen und damit die Länge der Anregungspulse zu reduzieren. Dies bedeutet, dass man die Information ausnutzt, welche in den unterschiedtichen räumlichen Variationen der Sendefelder der einzelnen Arrayelemente, im Folgenden auch als Sendeprofile bezeichnet, enthalten ist. Da die Länge solcher selektiver Anregungspulse meist eines der limitierenden Kriterien für die Anwendbarkeit dieser Technik war, ist die sog. Parallele Anregung (PEX: Parallel Excitation) ein viel versprechender Ansatz, um räumlich selektive Anregung in noch breiterer Weise einzusetzen als bisher geschehen.

Eine der Grundfragen beim Einsatz räumlich selektiver Anregung ist die Bestimmung der HF-Pulse, welche vom HF-Sendesystem abgespielt werden müssen, um in Kombination mit der gradientenerzeugten k-Raum-Trajektorie das gewünschte Anregungsmuster zu generieren. Im Artikel "A k-space analysis of small tip-angle excitation" [1] beschreiben Pauly et al. ein Verfahren für die einkanalige räumlich-selektive Anregung, mit welchem die gesuchte Pulsform $B_1$(t) aufgrund einer mathematischen Analogie der selektiven Anregung mit der Fourier-Bildgebung im Wesentlichen durch Fouriertransformation des gewünschten Anregungsmuster und Abtastung der Fouriertransformierten entlang der vorgegebenen k-Raum-Trajektorie berechnet werden kann. Katscher et al. erweiterten dieses Berechnungsverfahren für den Fall eines Antennenarrays mit mehreren unabhängigen Sendekanälen [2].

Ein entscheidender Nachteil der in diesen Artikeln beschriebenen Berechnungsverfahren ist jedoch, dass vielfältige experimentelle Faktoren, die die Realisierungstreue der Anregung negativ beeinflussen können und sich ggf. in von der jeweiligen k-Raum-Trajektorie abhängigen Artefakten äußern, nicht in der Berechnung berücksichtigt werden bzw. berücksichtigt werden können. Ein Beispiel für solche Einflussfaktoren sind Inhomogenitäten des magnetischen Grundfeldes, welche dafür sorgen, dass die Resonanzfrequenz der Kemspins an bestimmten Orten des Untersuchungsobjektes nicht mehr mit der eingestrahlten HF-Frequenz übereinstimmt, also Offresonanzen auftreten. Weiterhin sind die Relaxation des Spinsystems während der Pulse zu erwähnen sowie die Abweichung der realen k-Raum-Trajektorie von ihrer theoretischen, in der Berechnung vorgegebenen Form aufgrund von technischen Imperfektionen des Gradientensystems und von physikalischen Störeinflüssen, wie z. B. induzierten Wirbelströmen.

Als Folge dieser Nachteile sind nach und nach weitere Ansätze zur Pulsberechnung für räumlich selektive Anregung entstanden. In einigen Arbeiten [3,4] wurde der sog. ‚conjugate-phase' (CP)-Ansatz aus der Bildrekonstruktion herangezogen, welcher in der Lage ist, Offresonanzeffekte zu berücksichtigen und in gewissem Maße zu korrigieren. Trotz der Möglichkeit mit dem CP-Ansatz Offresonanzeffekte zu korrigieren, sind diese klassischen Ansätze zur Pulsberechnung in mehrerlei Hinsicht nicht optimal. Im Allgemeinen bringen die Algorithmen Pulse hervor, die hinsichtlich der Realisierungstreue des gewünschten Anregungsmusters suboptimal sind, insbesondere wenn die k-Raum-Trajektorie ein gewisses Undersampling aufweist oder wenn die Offresonanz-Einflüsse räumlich stark variieren. Eine neuere Methode zur Pulsberechnung, welche von Yip et al. [5] eingeführt und von Grissom et al. [6] für den Mehrkanal-Sendefall verallgemeinert wurde, beruht auf einem Optimierungsansatz und erzielt in zweifacher Hinsicht Verbesserungen bei der Anregungsgenauigkeit. Zum Einen ist sie robuster gegenüber Undersampling im k-Raum, zum Anderen kann sie Offresonanz-Einflüsse auf einfache Weise bei der Pulsberechnung berücksichtigen. Außerdem bietet sie die Möglichkeit, weitere Randbedingungen, wie die Kontrolle der integrierten oder auch der maximalen HF-Sendeleistung, in die Berechnung mit einfließen zu lassen, was im Hinblick auf die SAR-Kontrolle (SAR: Specific Absorption Rate, spezifische Absorptionsrate) oder auf technische Beschränkungen bei den HF-Leistungssendern von Bedeutung ist.

Ein generelles Problem auch dieser neuen Methoden ist jedoch, dass für die Korrektur von Offresonanzeffekten zunächst relativ genaue Karten der magnetischen Grundfeldvariationen im Bereich des Untersuchungsobjektes aufgenommen werden müssen, was vor allem unter in-vivo-Bedingungen oft problematisch ist. Möchte man mit diesen Methoden auch Effekte der transversalen Relaxation durch Vorausberechnung kompensieren, was theoretisch möglich ist, obwohl es in den entsprechenden Publikationen nicht explizit erwähnt wird, so ist auch hier eine detaillierte Bestimmung der Ortsabhängigkeit der $T_2$-Relaxationszeiten innerhalb des Untersuchungsobjektes erforderlich.

Ein weiteres Problem, welches bei den genannten Berechnungsverfahren überhaupt nicht berücksichtigt wird, sind die bereits angesprochenen Abweichungen der real durch die Gradienten erzeugten k-Raum-Trajektorie von der theoretisch vorgegebenen.

Es ist daher Aufgabe der vorliegenden Erfindung, ein Verfahren zur Gewinnung von Amplituden- und Phasenverläufen von HF-Pulsen für die ein- oder mehrkanalige räumlich-selektive Anregung anzugeben, bei welchem die angesprochenen experimentellen Imperfektionen, seien sie durch das

Untersuchungsobjekt oder physikalisch-technische Beschränkungen des Systems bedingt, berücksichtigt und intrinsisch kompensiert werden.

Diese Aufgabe wird durch ein Verfahren gemäß Patentanspruch 1 gelöst.

Die Bestimmung eines solchen HF-Pulses in diesem Verfahren erfolgt in mehreren Teilschritten.

Im ersten Teilschritt wird eine dem Problem angepasste k-Raum-Trajektorie gewählt, d.h. die Trajektorie muss den k-Raum in allen Dimensionen, in welchen eine räumliche Modulation der Transversalmagnetisierung vorgenommen werden soll, in ausreichender Weise abtasten. Im Rahmen einer Mehrkanalanregung kann dabei ein gewisser Grad an Undersampling zulässig sein, der durch die Anzahl der Arrayelemente und die Beschaffenheit deren räumlicher Sendeprofile nach oben begrenzt wird.

In einem zweiten Schritt wird nun ein zu der k-Raum-Trajektorie passender Satz von Basispulsen ausgewählt, wobei der Begriff "Puls" im Folgenden stets die Gesamtheit aller, ggf. über mehrere HF-Sendekanäle- und -Antennen, in einem bestimmten Zeitintervall ausgegebenen HF-Wellenformen bezeichnen soll. Dieser Satz von Basispulsen muss nicht zwingend vollständig sein, wie unten noch näher erläutert wird. In einer Reihe von MR-Experimenten, werden nun diese Basispulse nacheinander in Kombination mit der gewählten k-Raum-Trajektorie als Anregungspulse von der/den HF-Sendeantennen appliziert, wobei die k-Raum-Trajektorie, unabhängig davon, welcher Basispuls gerade verwendet wird, immer vollständig in gleicher Weise abgespielt wird, wobei die k-Raum-Trajektorie während jedes Basispulses zumindest ab dem Zeitpunkt, zu welchem die Pulsamplitude des Basispulses zum ersten Mal von null verschieden ist, vollständig identisch durchlaufen wird. Die k-Raum-trajektorie kann auch kurze zeit vor diesem zeitpunkt einsetzen. Dies ist jedoch nur dann angezeigt, wenn sichergestellt werden kann, dass der Verlauf der k-Raum-Trajektorie vor diesem Zeitpunkt sich nicht wesentlich auf die Trajektorie nach diesem Zeitpunkt auswirkt. Das Ergebnis jeder dieser MR-Experimente für jeweils einen einzigen Basispuls wird im Folgenden als ein Basismuster bezeichnet. Die Basismuster können je nach Art der räumlichen Selektion bei der Anregung und der Aufnahmemethode beispielsweise eindimensionale Verläufe (z. B. Schichtprofile), bzw. zwei- oder dreidimensionale Magnetresonanzbilder sein.

Es muss sichergestellt sein, dass die Basismuster in linearer Weise mit den Basispulsen zusammenhängen. Das bedeutet z. B., dass für jede lineare Superposition von Basispulsen der Einsatz dieser Superposition bei einem solchen Kalibrierungsexperiment zu einem Muster führen würde, welches der entsprechenden Superposition der zu den einzelnen Basispulsen gehörigen Basismuster entspricht. Bzgl. der Anregung ist eine solche lineare Abhängigkeit gegeben, solange man im Regime der "Small-Tip-Angle"-Approximation verbleibt. In diesem Regime gilt für das komplexe Anregungsmuster, sofern man Ofifresonanz- und transversale Retaxationseffekte berücksichtigt (hier im Falle einer Mehrkanalanregung):

$$M_{xy}(\mathbf{x}) = i\gamma M_0 \sum_n S_n(\mathbf{x}) \int_0^T B_{1,n}(t)\, e^{i\mathbf{x}\cdot\mathbf{k}(t)+i\omega_{off}(\mathbf{x})(t-T)+\frac{1}{T_2^*(\mathbf{x})}(t-T)}\, dt \qquad (1)$$

($M_{xy}$(x) ist das erzeugte Transversalmagnetisierungsmuster, **x** bezeichnet die Ortskoordinate, γ das gyromagnetische Verhältnis des untersuchten Spins, $M_0$ die Gleichgewichtsmagnetisierung (das magnetische Grundfeld ist in z-Richtung orientiert), $B_{1,n}$ die komplexe HF-Wellenform in Arrayelement $n$, $S_n$ die räumliche Variation des Sendefeldes von Arrayelement $n$, **k** die **k**-Raum-Trajektorie, $\omega_{off}$ die Offresonanzfrequenz, $T_2^*$ die effektive transversale Relaxationszeit und T die Dauer des Pulses. $M_{xy}$ und $B_{1,n}$ sind komplexe Größen, deren Real- und Imaginärteil die jeweilige x- bzw. y-Komponente in dem mit der HF rotierenden Koordinatensystem beschreibt (vektorielle Größen sind fettgedruckt).

Bildet man nun diese angeregte Transversalmagnetisierung z. B. mittels Fourier-Bildgebung unter Verwendung einer Standard-MRI-Bildgebungssequenz ab, so hängen die erhaltenen komplexen Bilder im Wesentlichen linear von den Basispulsen ab, sofern die Sequenz so beschaffen ist, dass das Messsignal linear vom Anregungsflipwinkel abhängt. Dies bedeutet, dass darauf zu achten ist, dass keine Sättigungseffekte, wie z. B. bei einer Gradientenecho-Sequenz mit zu kurzer Wiederholzeit, auftreten.

Der durch die beschriebenen Experimente erhaltene Satz von Basismustern dient nun als Grundlage für die Berechnung des für eine bestimmte, gewünschte Anregung benötigten Pulses. Die Berechnung erfolgt in der Weise, dass in einem Fitverfahren diejenige Linearkombination der Basismuster bestimmt wird, welche einem vorgegebenen Optimierungskriterium am besten entspricht. Ein solches Optimierungskriterium kann die Approximation eines vorgegebenen Zielmusters mit den Basismustern sein. Die Güte der Approximation kann über eine beliebige Kostenfunktion definiert werden. Man kann als Kostenfunktion aber auch direkt ein Funktional der Basismuster wählen, worüber dann als Zielmuster indirekt diejenige Linearkombination der Basismuster definiert ist, welche das Funktional minimiert. Ist nun diejenige Linearkombination der Basismuster gefunden, welche die Kostenfunktion minimiert, so lässt sich der gesuchte Puls als entsprechende Linearkombination der Basispulse berechnen. Je nach Art der Kostenfunktion, die eine Linearkombination der Basismuster, aber durchaus auch eine nichtlineare Funktion der Basismuster sein kann, muss ein geeignetes lineares bzw. nichtlineares Optimierungsverfahren ausgewählt werden. Solche Verfahren sind aus dem Stand der Technik bekannt.

Eine solche Optimierung kann in der Praxis vielfältige Formen annehmen. Der einfachste Fall wäre, dass der Empfang des MR-Signals mit einer einzigen homogenen HF-Empfangsantenne erfolgt und man ein einzelnes MR-Bild als Basismuster zu einem einzelnen Basispuls erhält. In diesem Fall ist das Basismuster proportional zur durch den Puls erzeugten Transversalmagnetisierung (im Allgemeinen nicht zum Flipwinkel, da das Objekt noch unterschiedlichen Spindichten aufweisen kann), wenn man von Relaxationseffekten absieht. Gibt man nun ein Zielmuster vor, so wird durch das Optimierungsverfahren der Puls bestimmt, welcher ein Muster der Transversalmagnetisierung erzeugt, das dem Zielmuster im Sinne der Kostenfunktion am nächsten kommt. Möchte man auf andere Parameter optimieren, wie z. B. den Flipwinkel, so muss man die Basismuster um die Spindichte im Objekt korrigieren, um Basismuster zu erhalten, die zum Flipwinkel proportional sind. Man kann beim Kalibrierungsverfahren auch zusätzliche Informationen akquirieren und die Basismuster mit diesen Zusatzinformationen modulieren, solange sichergestellt ist, dass der lineare Zusammenhang zwischen Basismuster und Basispuls erhalten bleibt.

Ein etwas komplexerer Fall liegt dann vor, wenn das Signal mit einem Array von m HF-Empfangssantennen akquiriert wird. Für jeden Basispuls wird von jeder HF-Empfangsantenne ein Einzelantennenbasismuster aufgenommen. Auf diese Art und Weise erhält man $m$ Sätze von Basismustern zu dem einen Satz von Basispulsen. Man kann nun die $m$ Sätze von Basismustern vor der Pulsermittlung durch Linearkombination der Einzelantennenbasismuster zu einem einzigen Satz von Bäsismustern kombinieren, wobei in jeder dieser Linearkombinationen jeweils nur Einzelantennenbasismuster eines bestimmten Basispulses kombiniert werden. Alternativ kann man auch im Zuge der Pulsermittlung zunächst mit den Basismustern innerhalb eines jeden Satzes die identische Linearkombination bilden und die so erhaltenen $m$ Zwischenmuster anschließend mit einer beliebigen, auch nichtlinearen Kombination zu einem Endmuster vereinigen, das dann ein Zielmuster approximieren soll. Identische Linearkombination bedeutet in diesem Fall, dass der Koeffizient, mit welchem ein bestimmtes Basismuster gewichtet wird für alle zu einem bestimmten Basispuls gehörenden Basismuster, unabhängig von ihrer Zugehörigkeit zu einem bestimmten Basismustersatz, derselbe ist.

Das beschriebene Verfahren bietet den großen Vorteil, dass Störeffekte, die so beschaffen sind, dass der linearen Zusammenhang zwischen Puls und Anregungsmuster bestehen bleibt, wie z.B. die zuvor beschriebenen Imperfektionen des MRI-Systems auf einfache Weise im Berechnungsverfahren der Pulse intrinsich berücksichtigt und damit kompensiert werden. Es entfällt eine aufwändige und unter schwierigen experimentellen Bedingungen oft instabile Messung von Parameterkarten. Da die Kalibrierung in-situ bereits mit der später verwendeten Messsequenz erfolgt, werden zusätzliche, üblicherweise bei Änderungen von Messbedingungen zu erwartende Störungen vermieden.

Je nach verwendeter k-Raum-Trajektorie ist der Kalibrierungsschritt im beschriebenen Verfahren mehr oder weniger aufwändig. Zur Verkürzung der Messzeit kann man ggf. auch Symmetrien des Experiments, welches zur Ermittlung der Basismuster dient, oder auch vorbekannte Systemeigenschaften ausnutzen, um aus einer Teilmenge der Basismuster weitere numerisch zu generieren. Dadurch kann ggf. die experimentelle Ermittlung der Basismuster auf diese Teilmenge reduziert werden.

Das folgende Ausführungsbeispiel soll die Erfindung unter Bezugnahme auf die beigefügten Abbildungen näher erläutern. Bei dem Ausführungsbeispiel handelt es sich um die Korrektur von $B_1$-Inhomogenitäten bei einer schichtselektiven 2D-MRI-Aufnahme.

Es zeigen:

Fig. 1    eine schematische Darstellung eines zur Durchführung des erfindungsgemäßen Verfahrens geeigneten MRI-Systems;

Fig. 2    eine schematische Darstellung eines zu untersuchenden Objektes mit den Schichten, in denen eine Abbildung erfolgen soll;

Fig. 3    ein Flussdiagramm eines möglichen Ablaufs von Kalibrierung-, Berechnungsschritt und Untersuchung;

Fig. 4    eine schematische Darstellung der für die Anregung verwendeten k-Raum-Trajektorie;

Fig. 5    eine schematische Darstellung des verwendeten HF-Sendeantennenarrays;

Fig. 6    einige Beispiele für verwendete Basispulse und die zugehörigen gemessenen Basismuster;

Fig. 7    ein mögliches Zielmuster;

Fig. 8    der berechnete Puls zur Erzeugung des Zielmusters aus Fig. 7;

Fig. 9    numerisch und experimentell erhaltene Muster unter Verwendung des berechneten Pulses aus Fig. 8; und

Fig. 10   einen Vergleich von Schnitten durch die numerisch und experimentell erhaltenen Muster aus Fig. 10.

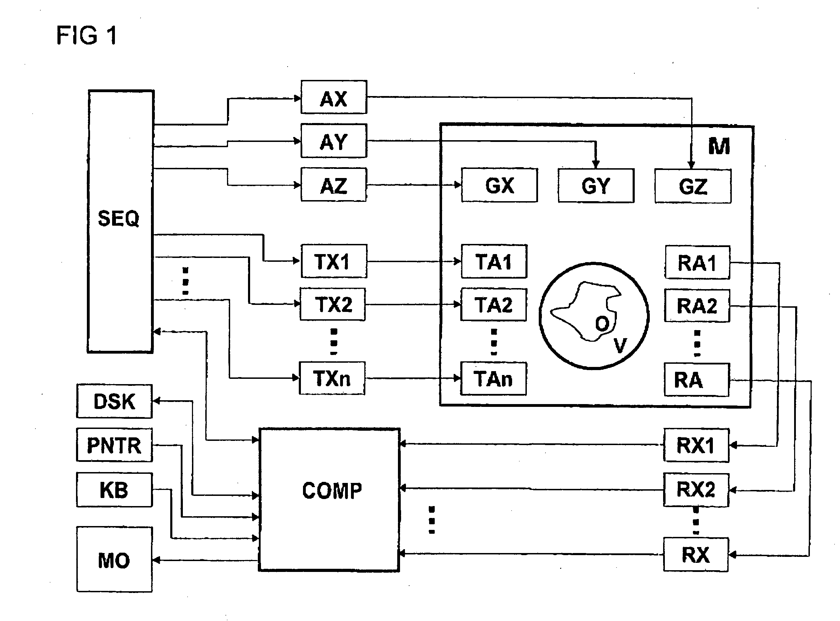

In **Fig. 1** ist schematisch ein MR-Messsystem dargestellt, das zur Durchführung des erfindungsgemäßen Verfahrens geeignet ist. Das System enthält einen Hauptmagneten **M,** mit welchem das in einem Untersuchungsvolumen **V** im Wesentlichen homogene und statische Grundmagnetfeld erzeugt wird. Dieses Untersuchungsvolumen V umgebend, sind in die Bohrung des Hauptmagneten **M** drei Sätze von Gradientenspulen **GX, GY,** und **GZ** eingebracht, mit denen zusätzliche Magnetfelder kontrollierbarer Dauer und Stärke mit konstanten Gradienten dem Grundfeld überlagert werden können. Mit Gradientenverstärkern **AX, AY** und **AZ,** die von einer Sequenzsteuereinheit **SEQ** zur zeitrichtigen Erzeugung von Gradientenpulsen angesteuert werden, werden die Gradientenspulen GX, GY, GZ mit elektrischem Strom zur Erzeugung von im Wesentlichen linearen Gradientenfeldern versorgt.

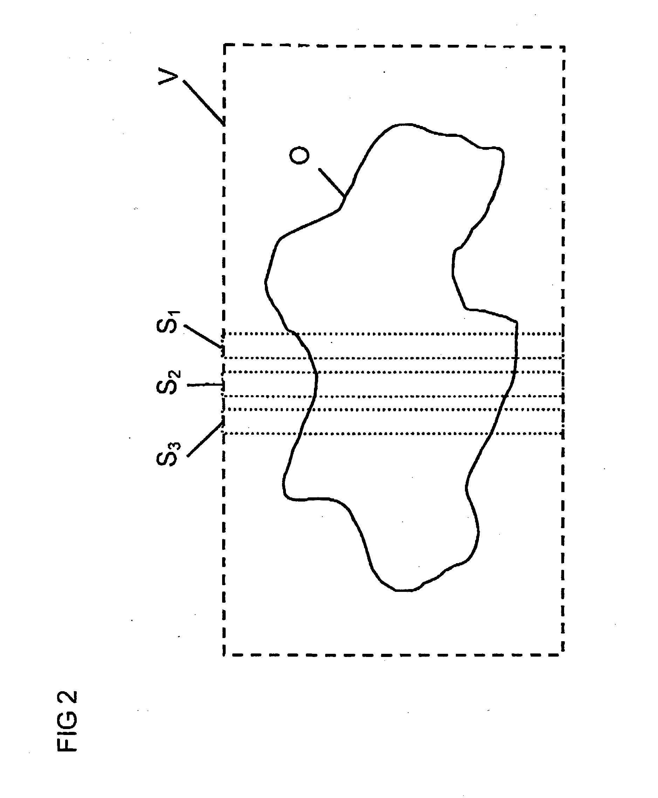

Innerhalb des Gradientenfeldsystems befinden sich mehrere HF-Sendeantennen **TA1** bis **TA*n*,** die in ihrer Gesamtheit auch als Sendearray, bestehend aus *n* Elementen, bezeichnet werden. Sie umgeben ein Untersuchungsobjekt O und werden von mehreren unabhängigen HF-Leistungssendern **TX1** bis **TX*n*** gespeist. Die von diesen Sendern erzeugten HF-Pulse werden von der Sequenzsteuereinheit SEQ bestimmt und zeitrichtig ausgelöst. Mit den HF-Sendeantennen TA1 bis TA*n* werden HF-Pulse auf das im Untersuchungsvolumen V befindliche Untersuchungsobjekt O eingestrahlt, siehe auch **Fig. 2,** und bewirken dort eine Anregung von Kernspins. Die dadurch hervorgerufenen Magnetresonanzsignale werden mit einer oder mehreren HF-Empfangsantennen **RA1,.., RA*m*,** die in ihrer Gesamtheit auch als Empfangsarray, bestehend aus *m* Elementen, bezeichnet werden, sich ebenfalls innerhalb der Gradientenspulen GX, GY, GZ befinden und das Untersuchungsobjekt O umgeben, in elektrische Spannungssignale umgesetzt, die dann in eine entsprechende Anzahl von Empfangseinheiten **RX1** bis **RX*m*** eingespeist werden. Zur Verringerung des apparativen Aufwandes kann das Antennensystem so ausgelegt und angeschlossen werden, dass eine oder mehrere der HF-Sendeantennen TA1 bis TAn auch zum Empfang der Magnetresonanzsignale genutzt werden. In einem solchen Fall, der in Fig. 1 nicht berücksichtigt ist, wird mittels einer bzw. mehrerer von der Sequenzsteuereinheit SEQ kontrollierter elektronischer Sende-Empfangsweichen für eine Umschaltung zwischen Sende- und Empfangsbetrieb gesorgt, d. h. dass während der HF-Sende-Phasen der ausgeführten Pufssequenz diese Antenne(n) mit dem bzw. den entsprechenden HF-Leistungssendern verbunden und von dem bzw. den zugeordneten Empfangskanälen getrennt ist/sind, während für die Empfangsphasen eine Senderabtrennung und eine Empfangskanalverbindung vorgenommen wird. Mit den in Fig. 1 dargestellten Empfangseinheiten RX1 bis RXm werden die empfangenen Signale verstärkt, unter Verwendung bekannter Signalverarbeitungsverfahren in digitale Signale gewandelt und diese an das elektronische Rechnersystem COMP weiterleitet. Neben der Rekonstruktion von Bildern aus den empfangenen Messdaten dient das Steuerrechnersystem COMP dazu, das gesamte MR-Messsystem zu bedienen und die Ausführung der Pulssequenzen durch entsprechende Kommunikation mit der Sequenzsteuereinheit SEQ zu initiieren. Die benutzergeführte oder automatische Ausführung von Programmen zur Justage der Messsystemeigenschaften und/oder zur Erzeugung von Magnetresonanzbildern erfolgt ebenso auf diesem Steuerrechnersystem COMP wie die Darstellung der rekonstruierten Bilder und die Speicherung und Verwaltung der Mess- und Bilddaten und der Steuerprogramme. Für diese Aufgaben ist dieses Rechnersystem mindestens mit einem Prozessor, einem Arbeitsspeicher, einer Computertastatur **KB,** einem Zeigeinstrument **PNTR,** z. B. einer Computermaus, einem Bildschirm **MON** und einer externen digitalen Speichereinheit **DSK** ausgerüstet.

Zur Verdeutlichung der Bildgebungssituation ist in **Fig. 2** innerhalb eines Untersuchungsvolumens V des Magnetresonanzsystems ein zu untersuchendes Objekt O dargestellt. Im vorliegenden Fall sollen Aufnahmen in einer oder mehreren Schichten $S_1, S_2, S_3$ usw. (hier stark vergrößert dargestellt) erzeugt werden. Als Beispiel soll nun innerhalb dieser Schichten $S_1$, $S_2$, $S_3$ durch selektive Anregung ein möglichst homogenes Bildprofil erreicht werden.

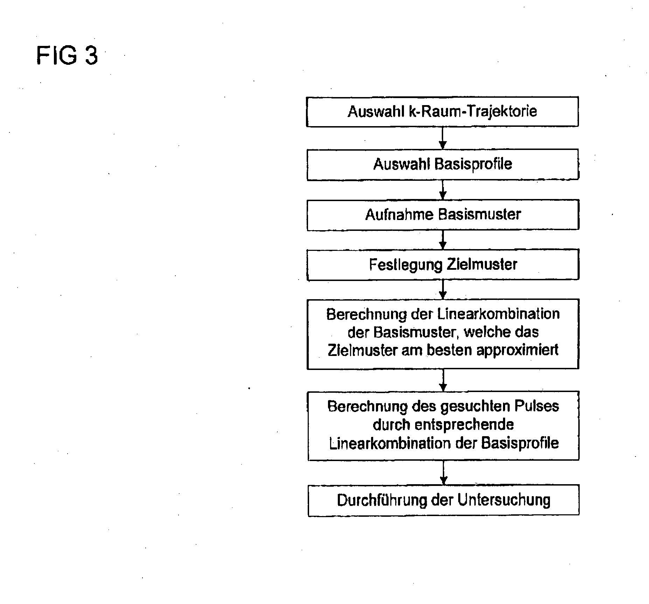

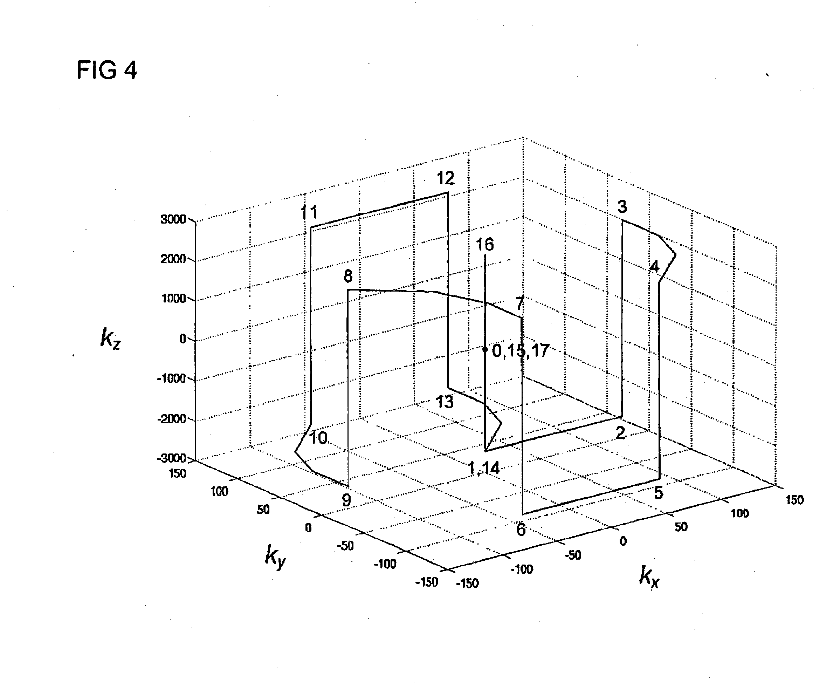

In Fig. 3 ist ein möglicher Messablauf dargestellt Der Messablauf beginnt zunächst damit, eine dem Problem angepasste k-Raum-Trajektorie auszuwählen. Da im vorliegenden Beispiel eine schichtselektive Anregung erfolgen soll, wobei innerhalb der Schicht eine Korrektur von räumlich langsam variierenden Inhomogenitäten des $B_1$-Feldes durchgeführt werden soll, bietet sich eine k-Raum-Trajektorie an, wie sie in **Fig. 4** dargestellt ist (die Trajektorie wird wie durch die aufsteigende Nummerierung 0 - 17 angegeben durchlaufen). Trajektorien dieser Art wurden von Saekho et al. [7] vorgeschlagen. Beim Durchlaufen einer solchen Trajektorie strahlt man schichtselektive Subpulse ein, und zwar vorzugsweise nur während die in z-Richtung orientierten Trajektorienteile, auch Speichen genannt, durchlaufen werden (2-3, 4-5, 6-7, 8-9, 10-11, 12-13, 14-16). Diese Subpulse haben identische Form können aber, je nach xy-Position auf der Trajektorie in globaler Amplitude und Phase variieren. Dadurch wird in z-Richtung eine Schichtselektion erreicht, in der xy-Ebene aber gleichzeitig eine Modulation des Transversalmagnetisierungsprofils innerhalb der Schicht erzielt.

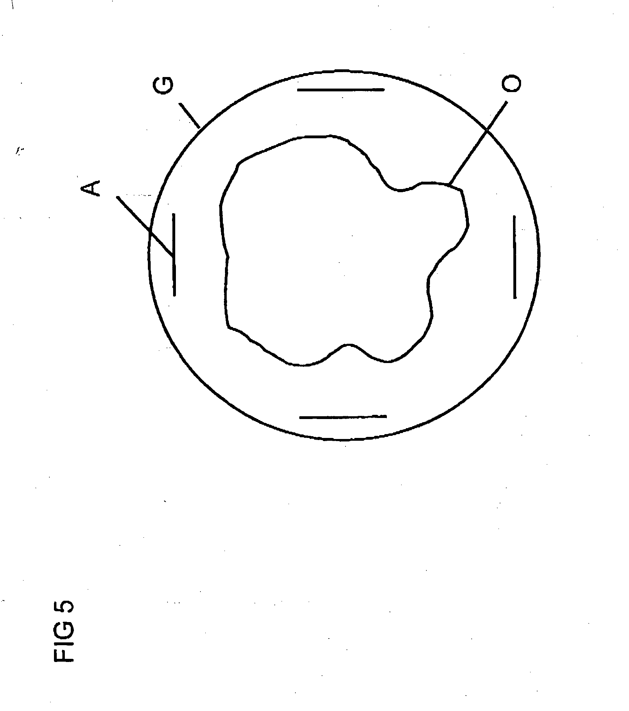

Nachdem die k-Raum-Trajektorie festgelegt ist, werden nun dazu passende Basispulse festgelegt. Im vorliegenden Fall weist die k-Raum-Trajektorie sieben Speichen in z-Richtung auf, während welcher die schichtselektiven Subpulse appliziert werden können. Außerdem wird in diesem Beispiel eine Anregung mit einem vier-elementigen Sendearray angenommen, welches von vier unabhängigen Sendekanälen getrieben wird. Ein Schema dieses Sendearrays ist in **Fig. 5** abgebildet. Es besteht aus einem Gehäuse G, in welchem vier Arrayelemente A angebracht sind, welche im vorliegenden Fall rotationssymmetrisch um das Untersuchungsobjekt O angeordnet sind. In diesem Fall besteht die Berechnung des HF-Pulses für ein bestimmtes Zielmuster darin, für alle sieben Positionen im k-Raum und alle vier Arrayelemente die Amplitude und Phase des Subpulses zu bestimmen, was mathematisch die Ermittlung von 28 komplexen Koeffizienten bedeutet. Daher wurde für die Kalibrierung ein Satz von 28 komplexen Basispulsen ausgewählt werden. Der für den vorliegenden Fall wohl einfachste Basissatz besteht darin, dass jeder Basispuls genau während einer der sieben Speichen in genau einem Arrayelement einen Subpuls mit einer Einheitsamplitude und Phase 0 beinhaltet. Dies ist aber nur einer von prinzipiell unendtich vielen möglichen Basissätzen. Es können auch Basispulse gewählt werden, in welchen an mehreren k-Raum-Stellen und in mehreren Arrayelementen nicht verschwindende Subpulse auftreten. Wichtig ist lediglich, dass die Basis linear unabhängig ist, d. h. kein Basispuls darf als lineare Superposition von anderen Basispulsen darstellbar sein.

Nach Auswahl der Basispulse werden nun die Messungen der Basismuster durchgeführt. Hierzu muss zunächst die Lage der Schichten ausgewählt werden, welche dann später auch in der eigentlichen Untersuchung verwendet werden sollen. Zur Aufnahme wurde im vorliegenden Fall eine Standard-Gradientenechosequenz verwendet, in welcher der Anregungspuls durch den beschriebenen schichtselektiven Puls mit $B_1$-Korrektur ersetzt wurde. Die Datenakquisition wurde mit demselben Array durchgeführt wie das Senden. Die Daten aus den vier Empfangskanälen wurden im Bildraum so kombiniert, als wenn das Array als Birdcage-Empfangsresonator mit einer Phasendifferenz von 90° zwischen benachbarten Elementen betrieben worden wäre. Man erhält also pro Kalibrierungsexperiment und Schicht je ein komplexes Bild. Um die Linearität zwischen Anregungsmuster und MR-Bild sicherzustellen, ist darauf zu achten dass der Anregungsflipwinkel bei den Basispulsen so gewählt wird, dass er in Abhängigkeit der Repetitionszeit der Gradientenechosequenz deutlich kleiner ist als der Ernst-Winkel.

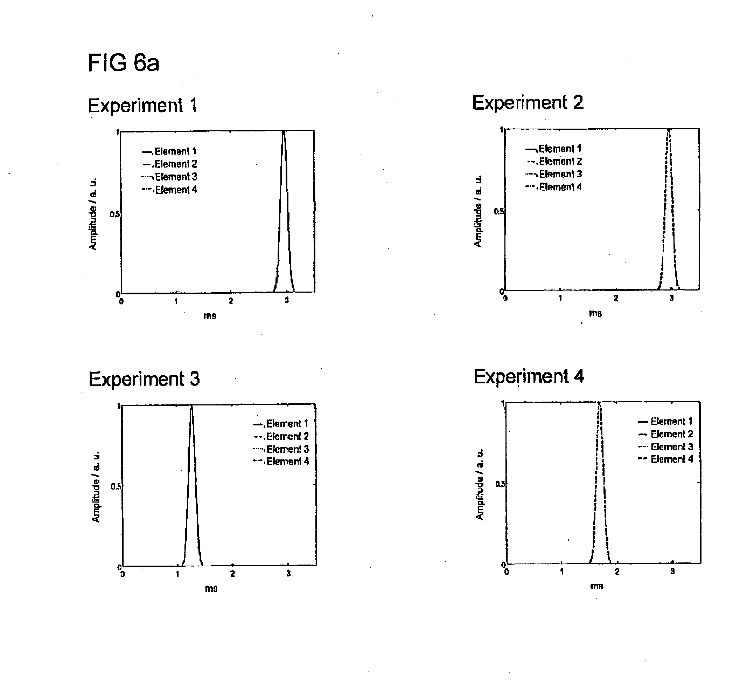

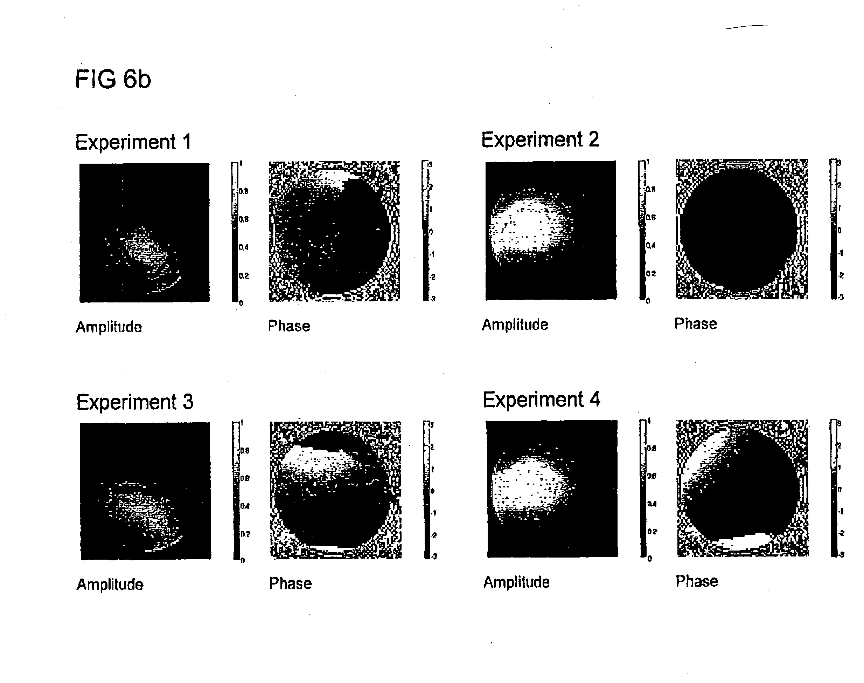

In **Fig. 6b** ist exemplarisch dargestellt, welche Basismuster im vorliegenden Fall durch einige ausgewählte Basispulse in einer axialen Schnittebene eines Wasserfläschchens erzeugt wurden. Im vorliegenden Beispiel wurde ohne Beschränkung der Allgemeinheit nur mit einer Schicht gearbeitet. In **Fig. 6a** sind zunächst vier verschiedene Basispulse, welche während der Kalibrierungsexperimente in dem Sendearray abgespielt wurden, dargestellt. In jedem Diagramm ist jeweils ein Basispuls mit seinen in den jeweiligen Arrayelementen abgespielten Komponenten dargestellt, wobei stets nur die Amplitude abgebildet ist, da die Phase jeweils identisch gleich null war. **Fig. 6b** zeigt die Betragsbilder der erzeugten Basismuster - die Intensität ist auf das Maximum der vier Betragsbilder normiert - sowie die graphische Darstellung des Phasenverlaufs (in rad). In den Experimenten 1 und 3 wurde jeweils nur mit Element 1 gesendet, jedoch an unterschiedlichen Stellen der Trajektorie. Daher erhält man bis auf minimale Effekte der transversalen Relaxation das gleiche Betragsbild, jedoch ergeben sich Unterschiede im Phasenverlauf. Für die Experimente 2 und 4 wurde nur mit Element 2 gesendet, daher unterscheiden sich die Basismuster von denen aus Experiment 1 und 3 auch im Betragsbild.

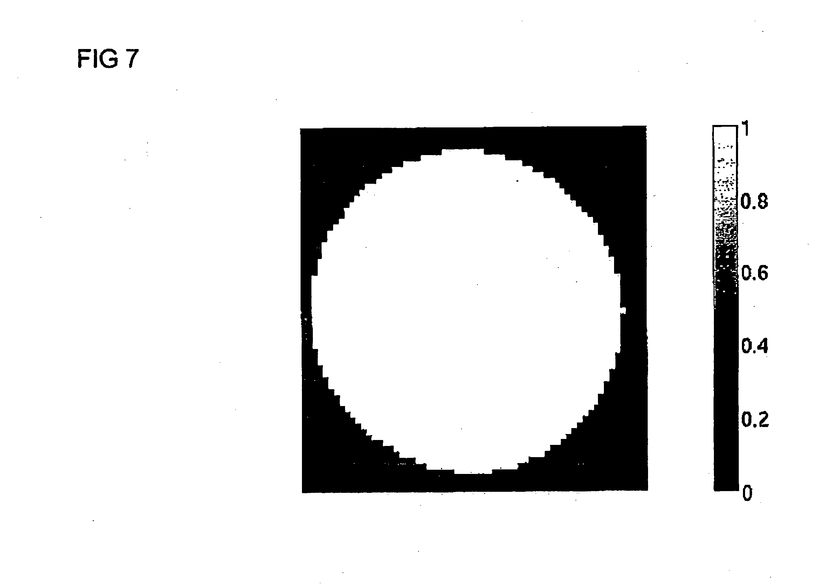

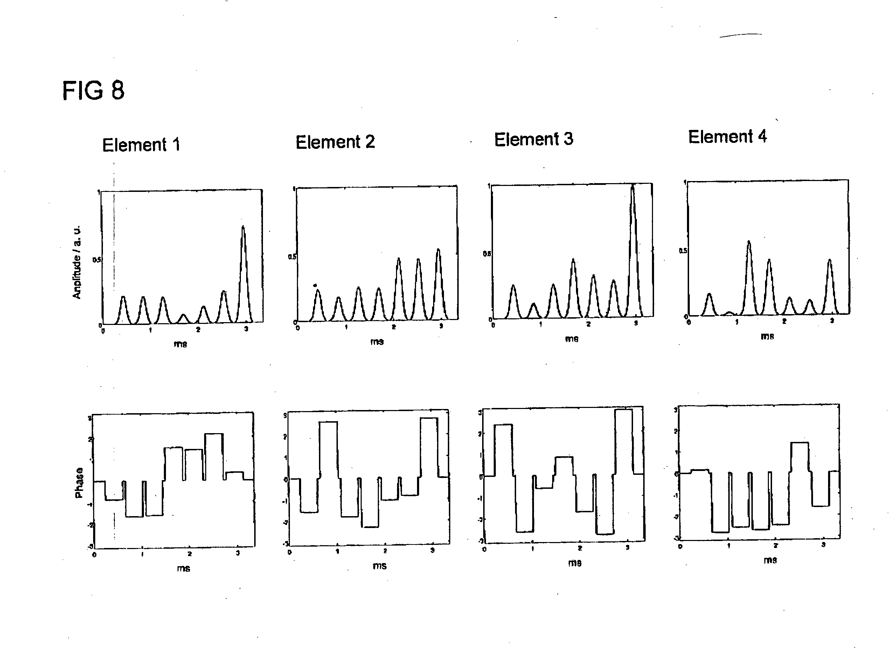

Nach Akquisition aller Basismuster kann nun die Berechnung des Pulses für ein gewünschtes Zielmuster erfolgen. Im vorliegenden Beispiel wurde als Zielmuster ein homogenes Bild mit einem Phasenverlauf, der konstant gleich 0 ist, vorgegeben. Der Betrag dieses Bildes ist in **Fig. 7** dargestellt. Durch Fitten der komplexen Basismuster an das Zielmuster erhält man nun die gesuchten 28 komplexen Koeffizienten. Ein einfaches Approximationskriterium ist in diesem Fall die kleinste quadratische Abweichung der Linearkombination der Basismuster vom Zielmuster. In **Fig. 8** sind die Amplituden und Phasenverläufe des somit ermittelten Pulses für die Anregung des Zielmusters dargestellt.

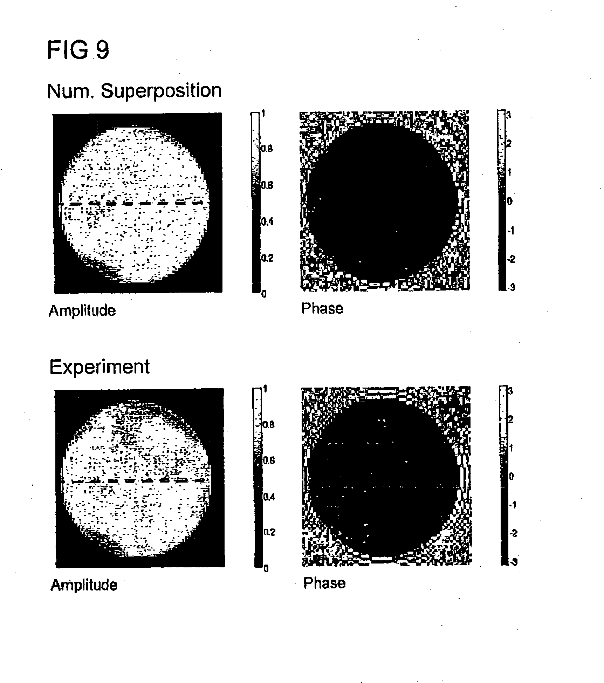

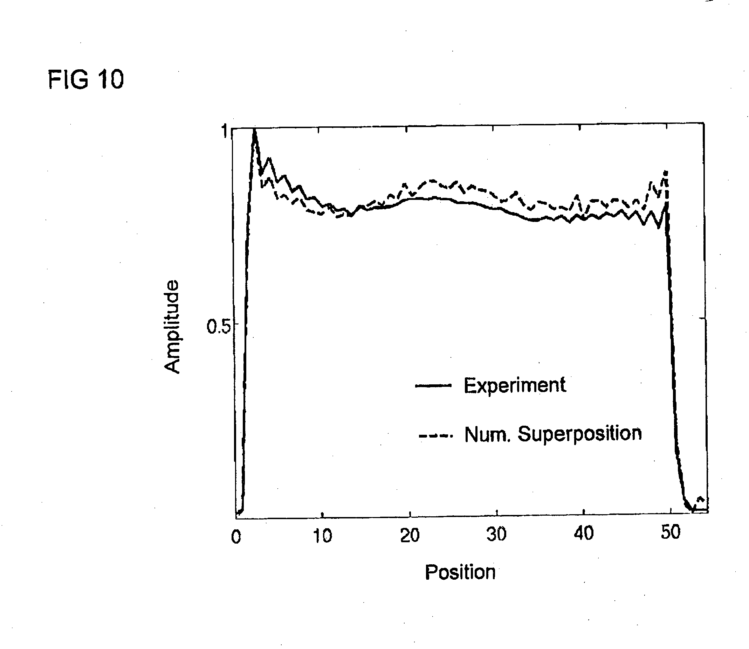

In **Fig. 9** ist dargestellt, welches Muster erhalten wird, wenn man die Basismuster mit den berechneten Koeffizienten numerisch superponiert. Weiterhin ist das Ergebnis eines MR-Experiments unter Verwendung des ermittelten Pulses abgebildet, welches eine sehr gute übereinstimmung mit der numerischen Superposition zeigt. Dies wird auch nochmals durch **Fig. 10** bekräftigt, in welcher zwei Schnitte durch die Betragsbilder aus **Fig. 9** entlang der dort eingezeichneten gestrichelten Linien miteinander verglichen werden.

An dieser Stelle soll nochmals explizit darauf hingewiesen werden, dass das Ausführungsbeispiel, wie voranstehend beschrieben, primär zu einem Bild mit homogenem Betrag führt, wenn man die Empfangssignale wie beschrieben kombiniert. Dies ist nicht notwendigerweise identisch mit einer homogenen Verteilung der erzeugten Transversalmagnetisierung, da der Signalempfang bzw. die Kombination der Empfangssignale nicht räumlich homogen sein muss, was im vorliegenden Beispiel der Fall ist. Möchte man also eine homogene Verteilung der Transversalmagnetisierung erzielen, so müsste man die Basismuster zunächst mit dem räumlichen Empfindlichkeitsprofil des verwendeten Empfangsmodus korrigieren. Möchte man gar einen homogenen Flipwinkel erzielen, so müsste man zusätzlich das Spindichteprofil des abzubildenden Objektes berücksichtigen.

Eine direktere Möglichkeit, im vorliegenden Fall zu einer homogenen Flipwinkelverteilung zu kommen, ist, zusätzlich zu den Basismustern noch für jedes Arrayelement eine Karte des Absolutbetrages ihres Sendefeldes aufzunehmen und den Betrag der Basismuster mit einer für die jeweiligen Sendearrayelemente verschiedenen, aber für alle k-Raum-Positionen desselben Elements identischen räumlichen Funktion zu multiplizieren, so dass das zu den einzelnen Elementen gehörige Basismuster in der k-Raum Mitte betragsmäßig gleich der jeweiligen Sendefeldkarte ist. Fittet man die so erhaltenen Muster an ein homogenes Muster, so erhält man einen Puls, welcher eine homogene Flipwinkelverteilung erzeugt.

Ein wichtiger Punkt bei dem in dieser Erfindung beschriebenen Verfahren ist auch die Dauer des Kalibrierungsschrittes. Wie bereits oben angedeutet muss es nicht immer notwendig sein, alle Basismuster experimentell zu bestimmen. Ggf. lässt sich auch ein Teil der Basismuster durch Symmetrieüberlegungen und vorbekannte Systemeigenschaften aus den übrigen bestimmen. Im vorliegenden Beispiel kann man, sofern man Effekte der transversalen Relaxation vernachlässigt, die Basismuster als Produkt aus einer durch das Sendeprofil des Arrayelements bestimmten Betrags- und Phasenverteilung und einer zusätzlichen durch die Position der Speiche in der k-Raum-Trajektorie gegebenen räumlich variierenden Phase, die aber für alle Elemente konstant ist, auffassen. Somit wäre es ausreichend, diejenigen Basismuster experimentell zu bestimmen, welche zu den Basispulsen gehören, die in den verschiedenen Arrayelementen jeweils während der zentralen Speiche einen Subpuls applizieren. Weiterhin müsste man noch für eines der Elemente, die zu allen Speichen gehörenden Basismuster ermitteln und könnte dann die übrigen Basismuster aus diesen gemessenen Mustern berechnen. Die Anzahl der Kalibrierungsexperimente würde sich dadurch von n x p auf n+p-1 reduzieren (p: Anzahl der Speichen in der k-Raum-Trajektorie, n: Anzahl der Arrayelemente). Im vorliegenden Beispiel wäre dies eine Reduktion um einen Faktor 2,8 von 28 auf 10 Experimente.

Das erfindungsgemäße Verfahren ermöglicht durch das Generieren einzelner Basismuster und durch die erfindungsgemäße Linearkombination der Basismustern die Bestimmung von für die ein- oder mehrkanalige räumlich-selektive Anregung geeigneten HF-Pulsen, wobei experimentelle Imperfektionen, berücksichtigt und intrinsisch kompensiert werden. Die gesuchten Pulse werden dabei durch eine der Linearkombination der Basismuster entsprechende Linearkombination bestimmt.

## Referenzen

[1] Pauly, J. ; Nishimura, D.; Macovski A.: A k-space analysis of small-tip-angle excitation. In: Journal of Magnetic Resonance 81 (1989), S. 43-56

[2] Katscher U.; Börnert, P.; Leussler, C.; van den Brink, J. S.: Transmit SENSE. In: Magnetic Resonance in Medicine 49 (2003), S. 144-150.

[3] Schomberg, H. ; Börnert, P. : Off-resonance correction of nD spatially selective RF pulses. In: Proceedings 6th Scientific Meeting, International Society for Magnetic Resonance in Medicine, Sydney, 1998, S. 2059

[4] Bömert, P. ; Aldefeld, B. : On spatially selective RF excitation and its analogy with spiral MR image acquisition. In: Magnetic Resonance Materials in Physics, Biology and Medicine 7 (1998), S. 166-178

[5] Yip, C.-Y.; Fessler, J. A.; Noll, D. C.: Iterative RF pulse design for multidimensional, small-tip-angle selective excitation. In: Magnetic Resonance in Medicine 54 (2005), S. 908-917

[6] Grissom, W.; Yip, C.-Y.; Zhang, Z.; Stenger, V. A.; Fessler, J. A.; Noll, D. C.: Spatial domain method for the design of RF pulses in multicoil parallel excitation. In: Magnetic Resonance in Medicine 56 (2006), S. 620-629

[7] Saekho, S.; Yip, C.-Y.; Noll, D. C.; Boada, F. E.; Stenger, V. A.: Fast-kz three-dimensional tailored radiofrequency pulse for reduced B1 inhomogeneity. In: Magnetic Resonance in Medicine 55 (2006), S. 719-724

## Patentansprüche

1. Verfahren zur Gewinnung der Amplituden- und Phasenverläufe von Hochfrequenzpulsen, welche während des Durchlaufens einer vorgegebenen k-Raum-Trajektorie zur Erzeugung eines n-dimensionalen räumlichen Musters, mit n>=1 der transversalen Magnetisierung in einem Objekt im Rahmen eines Experiments der ortsaufgelösten magnetischen Resonanz mittels mindestens einer HF-Sendeantenne eines Magnetresonanzmesssystems eingestrahlt werden,
**dadurch gekennzeichnet,**
**dass** in einem Kalibrierungsschritt

- ein Satz von Basispulsen vorgegeben wird, wobei ein Puls die Gesamtheit aller in der bzw. den verwendeten HF-Sendeantenne/n während eines Sendevorgangs abzuspielenden HF-Wellenformen bezeichnet,
- die Basispulse des Satzes einzeln eingestrahlt werden und dabei jeweils die vorgegebene k-Raum-Trajektorie durchlaufen wird und durch Detektion der durch die Einstrahlung dieser Basispulse angeregten MR-Signale mittels einer Empfangsvorrichtung mindestens ein Satz von Basismustern erzeugt wird, wobei jedes Basismuster zumindest in einem zu untersuchenden Bereich des Objekts zur von jeweils einem Basispuls erzeugten komplexen transversalen Magnetisierung proportional ist, wobei die k-Raum-Trajektorie während jedes Basispulses zumindest ab dem Zeitpunkt, zu welchem die Pulsamplitude des Basispulses zum ersten Mal von Null verschieden ist, vollständig identisch durchlaufen wird, und
**dass** in einem Berechnungsschritt ein vorgegebenes Zielmuster approximiert wird
- durch eine Linearkombination der Basismuster eines einzigen Satzes von Basismustern oder
- durch eine mathematische Verknüpfung von Zwischenmustern, welche durch Linearkombinationen innerhalb mehrerer Sätze von Basismustern erzeugt werden, wobei die Linearkombinationen innerhalb eines jeden Satzes von Basismustern identisch erfolgt , wobei eine identische Linearkombination vorliegt, wenn der Koeffizient, mit welchem ein bestimmtes Basismuster gewichtet wird, für alle zu einem bestimmten Basispuls gehörenden Basismuster, unabhängig von ihrer Zugehörigkeit zu einem bestimmten Satz von Basismustern, derselbe ist,

und die zu gewinnenden Amplituden- und Phasenverläufe der Hochfrequenzpulse als entsprechende Linearkombination der Basispulse erhalten werden.

2. Verfahren nach Anspruch 1, **dadurch gekennzeichnet, dass** für die Erzeugung der Basismuster mehrere HF-Empfangsantennen verwendet werden, wobei von jeder HF-Empfangsantenne der Empfangsvorrichtung jeweils ein separater Satz von Basismustern aufgenommen wird.

3. Verfahren nach Anspruch 2, **dadurch gekennzeichnet, dass** das Zielmuster im Berechnungsschritt durch Linearkombination der Basismuster innerhalb eines einzigen kombinierten Satzes von Basismustern approximiert wird, der dadurch erzeugt wird, dass Linearkombinationen von Basismustern mehrerer separater Sätze von Basismustern gebildet werden, wobei in jeder dieser Linearkombination jeweils nur Basismuster eines bestimmten Basispulses kombiniert werden.

4. Verfahren nach einem der vorhergehenden Ansprüche, **dadurch gekennzeichnet, dass** vor dem Berechnungsschritt aus mehreren Sätzen von Basismustern durch Linearkombination von verschiedenen jeweils durch einen bestimmten Basispuls erzeugten Basismustern ein einziger Satz von Basismustern erzeugt wird.

5. Verfahren nach einem der vorhergehenden Ansprüche, **dadurch gekennzeichnet, dass** die Linearkombinationen, mit denen innerhalb jedes Satzes die Basismuster identisch kombiniert werden, nicht linear, insbesondere durch Summation der Betragsquadrate, mathematisch verknüpft werden.

6. Verfahren nach einem der vorhergehenden Ansprüche, **dadurch gekennzeichnet, dass** die Sätze von vorgegebenen Basispulsen und den zugehörigen Basismustern unvollständig sind und durch Ausnutzung von vorbekannten Systemeigenschaften, insbesondere Symmetrien, ergänzt werden.

7. Verfahren nach einem der vorhergehenden Ansprüche, **dadurch gekennzeichnet, dass** beim Berechnungsschritt die Sätze von gemessenen Basismustern durch Ausnutzung von vorbekannten System- und/oder Objektelgenschaften modifiziert werden.

8. Verfahren nach einem der vorhergehenden Ansprüche, **dadurch gekennzeichnet, dass** das Zielmuster ein MR-Bild ist.

9. Verfahren nach Anspruch 7, **dadurch gekennzeichnet, dass** das Zielmuster eine räumliche Verteilung der transversalen Magnetisierung ist, wobei beim Berechnungsschritt die Empfangscharakteristik der Empfangsvorrichtung berücksichtigt wird.

10. Verfahren nach Anspruch 7, **dadurch gekennzeichnet, dass** das Zielmuster eine Zielflipwinkelverteilung ist, wobei beim Berechnungsschritt die Empfangscharakteristik der Empfangsvorrichtung sowie die Spindichteverteilung im Objekt berücksichtigt wird.

11. Verfahren nach einem der vorhergehenden Ansprüche, **dadurch gekennzeichnet, dass** das Zielmuster indirekt dadurch definiert ist, dass es ein auf den Linearkombinationen der Basismuster definiertes Funktional minimiert.

**Claims**

1. Method for determining amplitude and phase dependencies of radio frequency pulses that are irradiated during traversal of a defined k-space trajectory to produce an n-dimensional spatial pattern with $n \geqq 1$ of the transverse magnetization in an object as part of a spatially resolved magnetic resonance experiment using at least one RF transmission antenna of a magnetic resonance measurement system,
**characterized in that**
in a calibration step

- a set of basic pulses is defined, wherein a pulse refers to the totality of all RF wave shapes to be emitted in the RF transmission antenna(s) used during a transmission operation,
- each basic pulse of the set is irradiated singularly and the defined k-space trajectory is thereby traversed and at least one set of basic patterns is produced by detection of the MR signals excited by irradiation of these basic pulses using a reception device, wherein, at least in a range to be examined of the object, each basic pattern is proportional to the complex transverse magnetization produced by each basic pulse, wherein the k-space trajectory is traversed fully identically during each basic pulse at least from the point in time when the pulse amplitude of the basic pulse is not zero for the first time, and

that in a calculation step, a defined target pattern is approximated
- by a linear combination of the basic patterns of a single set of basic patterns or
- by a mathematical association of intermediate patterns which are generated by linear combinations within a plurality of sets of basic patterns, wherein the linear combinations within each set of basic patterns are identical, wherein an identical linear combination is present when the coefficient with which a specific basic pattern is weighted, is the same for all basic patterns that are associated with a specific basic pulse irrespective of their association with a specific set of basic patterns, and the amplitude and phase dependencies to be determined of the radio frequency pulses are obtained as a corresponding linear combination of the basic pulses.

2.  Method according to claim 1, **characterized in that** multiple RF reception antennas are used for production of the basic patterns, wherein a separate set of basic patterns is acquired by each respective RF reception antenna of the reception device.

3.  Method according to claim 2, **characterized in that** the target pattern is approximated in the calculation step by linear combination of the basic patterns within one single combined set of basic patterns, which is generated by forming linear combinations of basic patterns of several separate sets of basic patterns, wherein in each of these linear combinations only basic patterns of one specific basic pulse are combined in each case.

4.  Method according to any one of the preceding claims, **characterized in that**, before the calculation step, a single set of basic patterns is produced from multiple sets of basic patterns by linear combination of different basic patterns each produced by a specific basic pulse.

5.  Method according to any one of the preceding claims, **characterized in that** the linear combinations with which, within each set, the basic patterns are combined identically are mathematically associated nonlinearly, in particular, by summation of the squares of the absolute values.

6.  Method according to any one of the preceding claims, **characterized in that** the sets of defined basic pulses and the associated basic patterns are incomplete and are complemented by utilization of previously known system properties, in particular, symmetries.

7.  Method according to any one of the preceding claims, **characterized in that**, during the calculation step, the sets of measured basic patterns are modified by utilization of the previously known system and/or object properties.

8.  Method according to any one of the previous claims, **characterized in that** the target pattern is an MR image.

9.  Method according to claim 7, **characterized in that** the target pattern is a spatial distribution of the transverse magnetization, wherein, in the calculation step, the reception characteristic of the reception device is taken into account.

10. Method according to claim 7, **characterized in that** the target pattern is a target flip angle distribution, wherein, in the calculation step, the reception characteristic of the reception device and the spin density distribution in the object are taken into account.

11. Method according to any one of the preceding claims, **characterized in that** the target pattern is indirectly defined by the fact that it minimizes a functional defined from linear combinations of the basic patterns.

**Revendications**

1.  Procédé d'obtention des courbes d'amplitude et de phase d'impulsions à haute fréquence qui sont émises au moyen d'au moins une antenne émettrice HF d'un système de mesure par résonance magnétique pendant qu'elles parcourent une trajectoire prédéfinie dans l'espace k pour former un motif spatial n-dimensionnel avec n >= 1 de magnétisation transversale dans un objet dans le cadre d'une expérience de résonance magnétique à résolution spatiale,

**caractérisé en ce**

**que** dans une étape d'étalonnage

- un jeu d'impulsions de base est prédéfini, une impulsion désignant la totalité des formes d'onde HF à reproduire pendant un processus d'émission dans la ou les antenne(s) émettrice(s) HF utilisée(s),
- les impulsions de base du jeu sont émises individuellement et parcourent ce faisant chacune la trajectoire prédéfinie dans l'espace k, et par détection des signaux RM excités par l'injection de ces impulsions de base au moyen d'un dispositif de réception, au moins un jeu de motifs de base est produit, chaque motif de base étant proportionnel à la magnétisation transversale complexe produite par une impulsion de base au moins dans une zone à étudier de l'objet, la trajectoire dans l'espace k étant parcourue pendant chaque impulsion de base de manière complètement identique au moins à partir de l'instant auquel l'amplitude d'impulsion de l'impulsion de base est pour la première fois différente de zéro, et

**qu'**un motif cible prédéfini est approximé dans une étape de calcul
- par une combinaison linéaire des motifs de base d'un seul jeu de motifs de base ou
- par une combinaison mathématique de motifs intermédiaires qui sont produits par des combinaisons linéaires au sein de plusieurs jeux de motifs de base, les combinaisons linéaires au sein de chaque jeu de motifs de base étant effectuées de manière identique, une combinaison linéaire étant identique lorsque le coefficient avec lequel un motif de base défini est pondéré est le même pour tous les motifs de base appartenant à une impulsion de base définie, indépendamment de son appartenance à un jeu défini de motifs de base,

et **que** les courbes d'amplitude et de phase à obtenir des impulsions à haute fréquence sont obtenues sous la forme d'une combinaison linéaire correspondante des impulsions de base.

2. Procédé selon la revendication 1, **caractérisé en ce que** plusieurs antennes réceptrices HF sont utilisées pour la production des motifs de base, un jeu séparé de motifs de base étant capté par chaque antenne réceptrice HF du dispositif de réception.

3. Procédé selon une des revendications précédentes, **caractérisé en ce que** le motif cible dans l'étape de calcul est approximé par combinaison linéaire des motifs de base au sein d'un seul jeu combiné de motifs de base qui est produit en formant des combinaisons linéaires de motifs de base de plusieurs jeux séparés de motifs de base, seuls des motifs de base d'une impulsion de base définie étant combinés dans chacune de ces combinaisons linéaires.

4. Procédé selon une des revendications précédentes, **caractérisé en ce qu'**avant l'étape de calcul, un seul jeu de motifs de base est produit à partir de plusieurs jeux de motifs de base par combinaison linéaire de différents motifs de base produits chaque fois par une impulsion de base défini.

5. Procédé selon une des revendications précédentes, **caractérisé en ce que** les combinaisons linéaires avec lesquelles les motifs de base sont combinés de manière identique au sein de chaque jeu, sont combinées mathématiquement de manière non linéaire, en particulier par sommation des carrés du module.

6. Procédé selon une des revendications précédentes, **caractérisé en ce que** les jeux d'impulsions de base prédéfinies et les motifs de base associés sont incomplets et complétés par exploitation de propriétés connues du système, en particulier des symétries.

7. Procédé selon une des revendications précédentes, **caractérisé en ce que** dans l'étape de calcul, les jeux de motifs de base mesurés sont modifiés par exploitation de propriétés connues du système et/ou de l'objet.

8. Procédé selon une des revendications précédentes, **caractérisé en ce que** le motif cible est une image RM.

9. Procédé selon la revendication 7, **caractérisé en ce que** le motif cible est une distribution spatiale de la magnétisation transversale, la caractéristique de réception du dispositif de réception étant prise en compte dans l'étape de calcul.

10. Procédé selon la revendication 7, **caractérisé en ce que** le motif cible est une distribution cible d'angles de bascule, la caractéristique de réception du dispositif de réception ainsi que la distribution de densité de spin dans l'objet étant prises en compte dans l'étape de calcul.

11. Procédé selon une des revendications précédentes, **caractérisé en ce que** le motif cible est défini indirectement par le fait qu'il minimise une fonctionnelle définie sur les combinaisons linéaires des motifs de base.

FIG 1

EP 2 100 158 B1

FIG 2

FIG 3

Auswahl k-Raum-Trajektorie

→

Auswahl Basisprofile

→

Aufnahme Basismuster

→

Festlegung Zielmuster

→

Berechnung der Linearkombination der Basismuster, welche das Zielmuster am besten approximiert

→

Berechnung des gesuchten Pulses durch entsprechende Linearkombination der Basisprofile

→

Durchführung der Untersuchung

FIG 4

FIG 5

EP 2 100 158 B1

# FIG 6a

Experiment 1

Experiment 2

Experiment 3

Experiment 4

FIG 6b

FIG 7

FIG 8

# FIG 9

## Num. Superposition

Amplitude

Phase

## Experiment

Amplitude

Phase

EP 2 100 158 B1

FIG 10

EP 2 100 158 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 7078899 B2
- US 5758646 A

**In der Beschreibung aufgeführte Nicht-Patentliteratur**

- **PAULY.** *A k-space analysis of small tip-angle excitation*
- **PAULY, J. ; NISHIMURA, D. ; MACOVSKI A.** A k-space analysis of small-tip-angle excitation. *Journal of Magnetic Resonance,* 1989, vol. 81, 43-56
- **KATSCHER U. ; BÖRNERT, P. ; LEUSSLER, C. ; VAN DEN BRINK, J. S.** Transmit SENSE. *Magnetic Resonance in Medicine,* 2003, vol. 49, 144-150
- **SCHOMBERG, H. ; BÖRNERT, P.** Off-resonance correction of nD spatially selective RF pulses. *Proceedings 6th Scientific Meeting, International Society for Magnetic Resonance in Medicine, Sydney,* 1998, 2059
- **BÖMERT, P. ; ALDEFELD, B.** On spatially selective RF excitation and its analogy with spiral MR image acquisition. *Magnetic Resonance Materials in Physics, Biology and Medicine,* 1998, vol. 7, 166-178
- **YIP, C.-Y. ; FESSLER, J. A. ; NOLL, D. C.** Iterative RF pulse design for multidimensional, small-tip-angle selective excitation. *In: Magnetic Resonance in Medicine,* 2005, vol. 54, 908-917
- **GRISSOM, W. ; YIP, C.-Y. ; ZHANG, Z. ; STENGER, V. A. ; FESSLER, J. A. ; NOLL, D. C.** Spatial domain method for the design of RF pulses in multicoil parallel excitation. *Magnetic Resonance in Medicine,* 2006, vol. 56, 620-629
- **SAEKHO, S. ; YIP, C.-Y. ; NOLL, D. C. ; BOADA, F. E. ; STENGER, V. A.** Fast-kz three-dimensional tailored radiofrequency pulse for reduced B1 inhomogeneity. *Magnetic Resonance in Medicine,* 2006, vol. 55, 719-724